# EUROPÄISCHE PATENTSCHRIFT

(11) **EP 2 716 145 B1**
(45) Veröffentlichungstag und Bekanntmachung des Hinweises auf die Patenterteilung: **09.08.2017**
(21) Anmeldenummer: 12724310.3
(22) Anmeldetag: 22.05.2012
(51) Int. Cl.: H05K 1/18, H05K 3/20, H01L 23/538, B60L 3/00, B60L 11/00, B60L 11/14, H05K 1/02, H05K 3/46

(54) **LEITERPLATTE FÜR ELEKTRISCHE BAUELEMENTE UND LEITERPLATTENSYSTEM**
PRINTED CIRCUIT BOARD FOR ELECTRIC COMPONENTS, AND PRINTED CIRCUIT BOARD SYSTEM
CARTE DE CIRCUITS IMPRIMÉS POUR COMPOSANTS ÉLECTRIQUES ET SYSTÈMES DE CARTES DE CIRCUITS IMPRIMÉS

(30) Priorität: 23.05.2011 DE 102011076273
(43) Veröffentlichungstag der Anmeldung: 09.04.2014
(73) Patentinhaber: Continental Automotive GmbH, 30165 Hannover (DE)
(72) Erfinder: BREY, Roland, 93458 Eschlkam (DE); BERNHARDT, Andreas, 93173 Wenzenbach (DE)
(86) Internationale Anmeldenummer: PCT/EP2012/059482
(87) Internationale Veröffentlichungsnummer: WO 2012/160059

(56) Entgegenhaltungen:
- US-A- 4 630 174
- US-A1- 2007 059 918
- US-B1- 6 469 907

## Beschreibung

Die Erfindung betrifft eine Leiterplatte für elektrische Bauelemente, insbesondere zum Einsatz bei Hybrid- oder Elektrofahrzeugen, ein Leiterplattensystem und ein Kraftfahrzeug mit einer derartigen Leiterplatte.

Im Bestreben, den Kraftstoffverbrauch und die Schadstoffemissionen moderner Kraftfahrzeuge weiter zu reduzieren, kommen zunehmend Elektromotoren alleine (Elektrofahrzeug) oder in Kombination mit einer Brennkraftmaschine (Hybridfahrzeug) als Antrieb in Kraftfahrzeugen zum Einsatz. Die Versorgung der Elektromotoren mit elektrischer Energie erfolgt meist durch elektrochemische und/oder elektrostatische Energiespeicher. Zur Erzeugung einer ausreichend hohen Antriebsleistung kann der zwischen dem Energiespeicher und dem Elektromotor fließende Strom Stromstärken von mehreren hundert bis über tausend Ampere betragen.

Derart hohe Stromstärken erfordern eine entsprechend angepasste Steuer- und Schaltelektronik. Die Stromverteilung zwischen den genannten Komponenten erfolgt dabei meist mit Hilfe von Leistungshalbleiterschaltern, vorzugsweise MOSFETs. Diese Halbleiterschalter sind derart ausgebildet, dass sie auch Strom mit derart hohen Stromstärken sicher schalten können. Dabei sind diese Schaltelemente einer besonders hohen Hitzeentwicklung ausgesetzt, so dass eine ausreichend gute Kühlung notwendig ist, um ein Überhitzung dieser Schaltelemente zu vermeiden. Es handelt sich um gehäuste Schaltungselemente, bei denen das Halbleiterelement (der eigentliche Halbleiterschalter) zusammen mit einer meist metallischen Wärmesenke in einem gemeinsamen Gehäuse angeordnet ist. Die Wärmesenke (auch als heat slug bezeichnet) ist meist als im Gehäuse integrierter Kühlkörper ausgebildet, welcher am Gehäuseboden offen liegt. In der Regel werden diese Bauelemente auf eine Leiterplatte bestückt und die Anschlussbeine mit den stromführenden Leitern kontaktiert. Über das Lot wird diese Wärmesenke wärmeleitend an die Leiterplatte angebunden, so dass eine Wärmeabfuhr vom eigentlichen Halbleiterschalter zur Leiterplatte möglich ist. Aufgrund von Lunkern und Lufteinschlüssen im Lot unterhalb der Wärmesenke kann es zu einer verminderten Wärmeabfuhr kommen. Die Gefahr einer Überhitzung des Bauelements und damit eine Gefährdung der Betriebssicherheit der gesamten Schaltvorrichtung ist dadurch gegeben.

Die Druckschrift US 4,630,174 beschreibt ein Schaltungsmodul, bei dem ein Gehäuse einen Innenraum bildet, an dessen Innenseite Standteile befestigt sind, welche Halbleiter tragen. Die Schaltung innerhalb des Gehäuses ist freihängend innerhalb des Innenraums des Gehäuses befestigt.

Die Druckschrift US 2007/0059918 A1 betrifft eine Schaltungsanordnung, bei der auf einer Leiterplatte Halbleiterchips gemäß einer Gehäusestapelung (package on package, POP) angeordnet sind.

Es ist die Aufgabe der vorliegenden Erfindung einer Leiterplatte, ein Leiterplattensystem und ein Kraftfahrzeug bereitzustellen, welches sich durch eine erhöhte Betriebssicherheit auszeichnet.

Diese Aufgabe wird durch die Leiterplatte, das Leiterplattensystem und das Kraftfahrzeug gemäß den unabhängigen Ansprüchen gelöst. Vorteilhafte Ausgestaltungen der Erfindung werden durch die abhängigen Ansprüche beschrieben.

Eine Leiterplatte für elektrische Bauelemente gemäß dem Anspruch 1 weist zumindest einen Stromleiter auf, welcher als Formteil ausgebildet ist. Die Leiterplatte weist ferner zumindest ein ungehäustes elektrisches Bauelement auf, welches unmittelbar an dem Stromleiter befestigt ist.

Die der Erfindung zugrunde liegende Idee ist darin zu sehen, das Bauelement, welches mit Strom mit hoher Stromstärke durchflossen wird und einer starken thermischen Belastung ausgesetzt ist, als ungehäustes Bauelement auszugestalten und unmittelbar an dem Stromleiter anzuordnen bzw. zu befestigen. Der als massives Formteil ausgebildete Stromleiter weist eine hohe Wärmekapazität auf, sodass durch den wärmeleitenden Kontakt zwischen dem elektrischen Bauelement und dem Stromleiter eine sehr gute Kühlung des elektrischen Bauelements gewährleistet. Dadurch erweist sich auch die Qualität der wärmeleitenden Anbindung des Bauelements an den Stromleiter als weniger kritisch, wie es beispielsweise bei den aus dem Stand der Technik bekannten Anordnungen der Fall ist. Die Leiterplatte zeichnet sich demnach durch eine deutlich verbesserte Kühlung des Bauelements aus, wodurch die Gefahr einer Überhitzung des elektrischen Bauelements deutlich reduziert wird. Die Betriebssicherheit der Leiterplatte wird dadurch deutlich erhöht.

In einer Ausgestaltung der Leiterplatte nach Anspruch 2 ist der mindestens eine Stromleiter als massiver Flachleiter mit rechteckigem Querschnitt ausgebildet.

In einer weiteren Ausgestaltung der Leiterplatte nach Anspruch 3 ist der zumindest eine Stromleiter derart ausgebildet, dass er in der Lage ist, Strom mit Stromstärken über 500 Ampere zu leiten.

Derart ausgebildete Stromleiter können sehr kostengünstig aus Strangprofilen hergestellt werden. Durch die Ausbildung als Flachleiter ist auch eine sehr einfache und unproblematische Montage des ungehäusten elektrischen Bauelements unmittelbar auf dem Stromleiter möglich.

In einer Ausgestaltung der Leiterplatte nach Anspruch 4 ist das zumindest eine ungehäuste elektrische Bauelement an dem Stromleiter mittels einer dazwischen liegenden Schicht aus wärmeleitendem Material befestigt.

Als mögliche Materialien zur Befestigung des elektrischen Bauelements an dem Stromleiter kommen beispielsweise Lot, Leitkleber oder wärmeleitende, doppelseitig klebende Folien in Frage. Durch die unmittelbare thermische Anbindung des ungehäusten elektrischen Bauelements an den Stromleiter vermindern Lufteinflüsse oder Lunker zwar die Wärmeleitfähigkeit dieser Schicht, jedoch nicht soweit dass es zu einer Beschädigung des Bauteils kommt.

Die erfindungsgemäße Leiterplatte weist einen Trägerkörper auf, sowie zumindest eine Schicht aus elektrisch isolierendem Material, welche den Trägerkörper, den mindestens einen Stromleiter und das zumindest eine ungehäuste elektrische Bauelement zumindest teilweise bedeckt. Die Schicht aus elektrisch isolierendem Material weist zumindest einen Durchbruch auf, durch den zumindest das eine ungehäuste elektrische Bauelement elektrisch kontaktierbar ist.

Die Schicht auf isolierendem Material kann beispielsweise aus in einer duroplastischen Kunststoffmatrix eingebetteten Endlosfasern bestehen, welche unter hohen Temperaturen aushärtet. Diese im Fachjargon auch als "Prepreg" bezeichnete Fasermatrix lässt sich maschinell leicht verarbeiten. Der zumindest eine Durchbruch kann großflächig gefräst, als Bohrung oder Microvia ausgestaltet sein. Auf diese Weise kann der Stromleiter und/oder das ungehäuste elektrische Bauelement sicher elektrisch isoliert und mittels der Durchbrüche in der elektrisch isolierenden Schicht gezielt elektrisch kontaktiert werden.

In einer Ausgestaltung der Leiterplatte nach Anspruch 5 weist diese zumindest zwei Stromleiter auf, welche als Formteil ausgebildet sind, wobei es sich bei dem zumindest einem ungehäusten elektrischen Bauelement um einen Halbleiterschalter handelt, der an einem der Stromleiter befestigt und durch den zumindest einen Durchbruch in der elektrisch isolierenden Schicht mit dem zweiten Stromleiter elektrisch verbunden ist. Bei dem als Halbleiterschalter ausgebildeten ungehäusten elektrischen Bauelement kann es sich beispielsweise um einen MOSFET handeln. Dieser ist in der Lage, auch Strom mit hoher Stromstärke von über 500 bis über 1000 Ampere zu schalten. Durch die Anordnung wird die in dem Halbleiterschalter erzeugte hohe Wärme unmittelbar an den als Formteil ausgebildeten Stromleiter abgeführt, was zu einer sicheren Kühlung des Halbleiterschalters führt. Ein Überhitzen und somit eine Beschädigung des Halbleiterschalters wird vermieden, wodurch die Schalteinheit in ihrer Betriebssicherheit deutlich verbessert wird.

In einer Ausgestaltung der Leiterplatte nach Anspruch 6 weist diese zumindest eine Steuerelektronik auf, welche durch den Durchbruch mit dem ungehäusten elektrischen Bauelement elektrisch verbunden ist.

Durch Ausbildung von Durchbrüchen in der elektrisch isolierenden Schicht kann das ungehäuste elektrische Bauelement nicht nur mit anderen Stromleitern sondern auch mit beliebig anderen elektrischen Bauelementen der Leiterplatte kontaktiert werden. So kann es sich um eine Steuerelektronik handeln, welche - je nach Ausführung des ungehäusten elektrischen Bauelements - diesem Steuersignale zuführen oder auch Daten von diesen beziehen kann (beispielsweise wenn es sich bei dem elektrischen Bauelement um einen Sensor handelt). Diese Ausgestaltung realisiert deshalb auf einfache, kostengünstige und betriebssichere Weise eine elektrische Verbindung des ungehäusten elektrischen Bauelements mit einer Steuerelektronik.

In einer Ausgestaltung der Leiterplatte nach Anspruch 7 weist der Trägerkörper zumindest eine Ausnehmung zur Aufnahme des Stromleiters auf. Der Stromleiter ist dabei in der Ausnehmung des Trägerkörpers angeordnet.

Bei dieser Ausgestaltung der Leiterplatte ist der zumindest eine Stromleiter in den Trägerkörper der Leiterplatte integriert. Die Ausnehmungen zur Aufnahme der Stromleiter können beispielsweise als Vertiefung oder als Durchbruch im Trägerkörper ausgebildet sein. Im Falle einer Vertiefung liegt der darin angeordnete Stromleiter nur an einer Seite frei, während er auf allen anderen Seiten durch das Trägermaterial elektrisch isoliert ist. Im Falle einer Ausbildung der Ausnehmung als Durchbruch ist der darin angeordnete Stromleiter auf zwei gegenüberliegenden Seiten frei zugänglich, so dass auf beiden Seiten eine Montage von ungehäusten elektrischen Bauelementen möglich ist. Die Integration des Stromleiters in die Leiterplatte hat ferner zum Vorteil, dass weitere elektrische Bauelement auf der Leiterplatte angeordnet werden können und somit Leistungselektronik mit herkömmlicher Elektronik kombiniert werden kann. Dadurch ergibt sich eine besonders hohe Integrationsdichte was Bauraum und Kosten spart.

In einer Ausgestaltung der Leiterplatte nach Anspruch 8 weist diese eine Schicht aus elektrisch leitendem Material auf, welche auf der elektrisch isolierenden Schicht aufgebracht und als elektrische Leiterstruktur ausgebildet ist. Das ungehäuste elektrische Bauelement ist durch den mindestens einen Durchbruch in der elektrisch isolierenden Schicht mit der elektrisch leitenden Schicht elektrisch verbunden.

Die Schicht aus elektrisch leitendem Material besteht vorzugsweise aus Kupfer oder einer Kupferlegierung. Die Leiterstruktur kann durch einen Ätzvorgang erzeugt werden. Bei dieser Ausgestaltung ist es daher möglich, das ungehäuste elektrische Bauelement über den Durchbruch in der elektrisch isolierenden Schicht mit der elektrischen Leiterstruktur zu verbinden und so mit weiteren Bauelementen oder Stromleitern an einer beliebigen anderen Stelle der Leiterplatte zu verbinden.

Ein Leiterplattensystem gemäß dem Anspruch 9 weist zumindest eine erste Leiterplatte nach einem der Ansprüche 1 bis 8 und zumindest eine zweite Leiterplatte mit elektrischen Bauelementen auf. Das Leiterplattensystem weist ferner einen Verbindungsabschnitt aus elektrisch isolierendem Material auf, mittels dem die erste Leiterplatte und die zweite Leiterplatte miteinander verbunden sind.

Bei diesem Leiterplattensystem sind zwei Leiterplatten miteinander verbunden, was zu einer hohen Integrationsdichte der darauf angeordneten Elektronik führt. Die Leiterplatten können beispielsweise für unterschiedliche Stromstärken ausgelegt sein. So ist es möglich, dass die erste Leiterplatte für hohe Stromstärken von mehreren 100 bis über 1000 Ampere die zweite Leiterplatte im Bereich von Milliampere ausgelegt ist. Das Leiterplattensystem zeichnet sich durch einen geringen Platzbedarf, eine kostengünstige Herstellung, kurze Verbindungswege und eine hohe Betriebssicherheit auf.

In einer Ausgestaltung des Leiterplattensystems nach Anspruch 10 ist der Verbindungsabschnitt als elektrisch isolierende Schicht zwischen einer Hauptfläche der ersten Leiterplatte und einer Hauptfläche der zweiten Leiterplatte ausgebildet.

Als Hauptflächen sind dabei die Flächen der jeweiligen Leiterplatte zu verstehen, welche mit elektrischen Bauelementen bestückt werden können. Durch den Verbindungsabschnitt werden diese beiden, eventuell mit Bauelementen und einer elektrischen Leiterstruktur versehenen Hauptflächen gegeneinander sicher elektrisch isoliert. Gleichzeitig können Bauelemente oder auch Stromleiter der ersten und zweiten Leiterplatte untereinander über sehr kurze elektrische Verbindungswege miteinander beliebig kombiniert sein.

In einer Ausgestaltung des Leiterplattensystems nach Anspruch 11 weist die erste Leiterplatte und die zweite Leiterplatte und die zweite Leiterplatte einen gemeinsamen Trägerkörper auf. Ein zwischen der ersten Leiterplatte und der zweiten Leiterplatte befindlicher Abschnitt des gemeinsamen Trägerkörpers stellt den Verbindungsabschnitt dar. Dieses ist derart verformt, dass zwei Hauptflächen der ersten Leiterplatte und der zweiten Leiterplatte einander zugewandt sind.

Bei dieser Ausgestaltung des Leiterplattensystems sind die eventuell mit Bauelementen und einer Leiterstruktur versehenen Hauptflächen der Leiterplatten zueinander zugewandt jedoch durch einen Luftspalt voneinander elektrisch isoliert. Die Verformung des Verbindungsabschnitts kann beispielsweise dadurch erfolgen, dass der Verbindungsabschnitt im Querschnitt verjüngt und anschließend unter Erwärmung gebogen wird.

In einer Ausgestaltung des Leiterplattensystems nach Anspruch 12 sind die erste Leiterplatte und/oder die zweite Leiterplatte als mehrlagige Leiterplatte ausgebildet.

Auf diese Weise kann eine weitere Verdichtung der Elektronik und eine weitere Verstärkung der Integrationstiefe erreicht werden.

In einer Ausgestaltung des Leiterplattensystems nach Anspruch 13 weist die zweite Leiterplatte eine Steuerelektronik auf.

Bei dieser Ausgestaltung ist die Leistungselektronik auf der ersten Leiterplatte von der zugehörigen Steuerelektronik auf der zweiten Leiterplatte elektrisch isoliert, jedoch im selben Leiterplattensystem integriert. Auf diese Weise ergeben sich kurze Übertragungswege und ein geringer Bauraum.

Ein Kraftfahrzeug gemäß dem Anspruch 14 weist zumindest einen elektrischen Motorgenerator und zumindest einen elektrischen Energiespeicher auf, welcher mit dem Motorgenerator elektrisch verbunden ist. Das Kraftfahrzeug weist ferner eine Steuervorrichtung zum Steuern des elektrischen Energieflusses zwischen dem mindestens einen elektrischen Energiespeicher und dem mindesten einen Motorgenerator auf, wobei die Steuervorrichtung zumindest eine Leiterplatte nach einem der Ansprüche 1-8 aufweist. Eine Leiterplatte nach den Ansprüchen 1 bis 8 der ein Leiterplattensystem nach einem der Ansprüche 9 bis 13 weisen sich durch einen kompakten Aufbau eine hohe Betriebssicherheit und geringe Herstellungskosten auf. Sie eignen sich insbesondere zum Steuern des elektrischen Energieflusses zwischen beispielsweise einem elektrochemischen Energiespeicher, einem elektrostatischen Energiespeicher zur Spannungsstabilisierung und den Motorgenerator.

Im Folgenden wird die Erfindung anhand von Ausführungsbeispielen mit Bezug auf die beigefügten Figuren näher erläutert. In den Figuren sind:
- Figur 1: eine schematische Darstellung eines Fahrzeugs mit Hybridantrieb;
- Figur 2: eine schematische Darstellung eines Ausführungsbeispiels für eine Leiterplatte;
- Figuren 3A und 3B: schematische Darstellungen eines Stromleiters mit einem ungehäusten elektrischen Bauelement;
- Figuren 4A und 4B: schematische Darstellungen eines Trägerkörpers der Leiterplatte;
- Figur 5: eine schematische Darstellung eines ersten Ausführungsbeispiels eines Leiterplattensystems;
- Figur 6: eine schematische Darstellung eines zweiten Ausführungsbeispiels eines Leiterplattensystems.

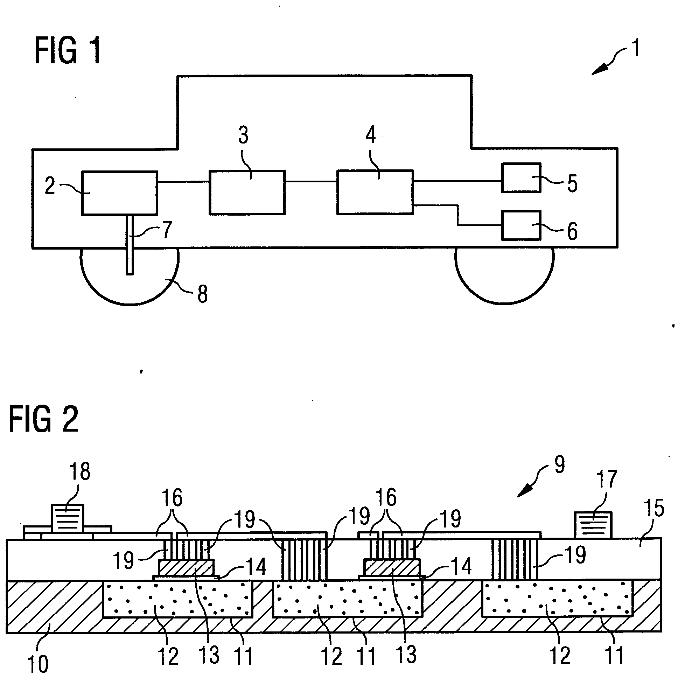

In Figur 1 ist ein Kraftfahrzeug 1 mit Hybridantrieb schematisch dargestellt. Das Fahrzeug 1 weist einen Brennkraftmaschine 2, einen elektrischen Motorgenerator 3, eine Steuerungsvorrichtung 4, einen elektrochemischen Energiespeicher 5 (Batterie) und einen elektrostatischen Energiespeicher 6 (ein oder mehrere Kondensatoren) auf. Die Steuervorrichtung 4 ist mit dem Motorgenerator 3 und den elektrischen Energiespeichern 5, 6 über elektrische Leitungen verbunden.

Das Kraftfahrzeug 1 kann je nach Fahrsituation allein durch die Brennkraftmaschine 2, allein durch den Motorgenerator 3 oder durch beide gleichzeitig angetrieben werden. Dazu ist der die Brennkraftmaschine 2 über einen Antriebsstrang 7 mit den Antriebsrädern 8 verbunden, so dass ein von der die Brennkraftmaschine 2 erzeugtes Drehmoment an die Antriebsräder übertragen werden kann. Im Ausführungsbeispiel ist der Motorgenerator 3 mit der Brennkraftmaschine 2 derart gekoppelt, so dass ein vom Motorgenerator 3 erzeugtes Drehmoment die Brennkraftmaschine 2 antreiben kann, was wiederum über den Antriebsstrang 7 auf die Antriebsräder weitergeleitet wird. Der Motorgenerator 3 kann als elektrischen Antrieb oder als Generator wirken, so dass ein von der Brennkraftmaschine 2 erzeugtes Drehmoment durch den Motorgenerator 3 in elektrischen Strom umgewandelt werden kann. Dies erfolgt vorzugsweise in einem Schubbetrieb des Kraftfahrzeugs.

Der Motorgenerator 3 wird in seiner Funktion als elektrischer Antriebsmotor von dem elektrochemischen Energiespeicher 5 und/oder dem elektrostatischen Energiespeicher 6 mit elektrischer Energie versorgt. In seiner Funktion als Generator wird die vom Motorgenerator 3 erzeugte elektrische Energie im elektrochemischen Energiespeicher 5 und im elektrostatischen Energiespeicher 6 gespeichert. Den Stromfluss zwischen dem Motorgenerator 3 und den elektrischen Energiespeichern 5, 6 steuert die zwischengeschaltete Steuervorrichtung 4. Der dabei fließende Strom kann Stromstärken von mehreren hundert Ampere bis über tausend Ampere betragen. Aus diesem Grund sind an die in der Steuervorrichtung 4 enthaltene Schaltungselektronik sehr hohe Ansprüche hinsichtlich der Betriebssicherheit gestellt.

Im Folgenden werden eine Leiterplatte und ein Leiterplattensystem vorgestellt, welches Bestandteil der Steuerungsvorrichtung sind, und welche in der Lage sind, den elektrischen Energiefluss zwischen dem Motorgenerator 3 und den elektrischen Energiespeichern 5, 6 mit hoher Betriebssicherheit zu koordinieren.

In Figur 2 ist ein Ausführungsbeispiel einer Leiterplatte 9 für elektrische Bauelemente im Querschnitt schematisch dargestellt. Eine derartige Leiterplatte 9 kann in der Steuervorrichtung 4 des Kraftfahrzeugs 1 (siehe Figur 1) zum Schalten des zwischen dem Motorgenerator 3 und den elektrischen Energiespeichern 5,6 fließenden Stroms eingesetzt werden.

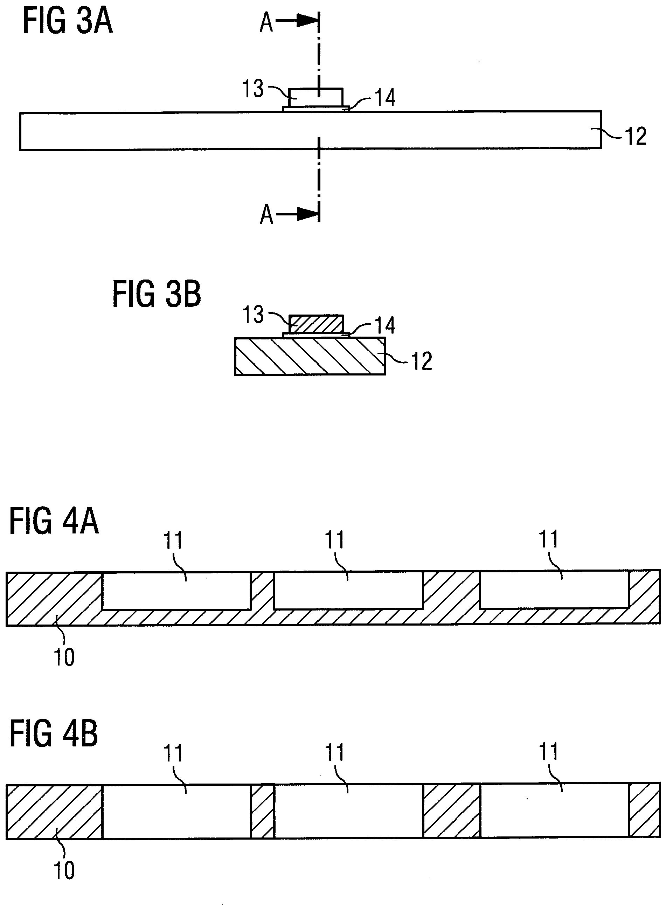

Die Leiterplatte 9 weist einen Trägerkörper 10 aus elektrisch isolierendem Material (beispielsweise mit Epoxidharz getränkte Glasfasermatten) auf. Der Trägerkörper 10 ist in den Figuren 4A und 4B vereinzelt dargestellt. In dem Trägerkörper 10 sind Ausnehmungen 11 zur Aufnahme eines Stromleiters ausgebildet. Diese können beispielsweise durch nachträgliches Fräsen des Trägerkörpers 10 gebildet werden. Die Ausnehmungen können sowohl als Aussparungen (Figur 4A) oder als vollständige Durchbrüche (Figur 4B) ausgebildet sein.

Die Leiterplatte (siehe Figur 2) weist ferner drei Stromleiter 12 und zwei ungehäuste elektrische Bauelemente 13 auf, welche auf jeweils einem der Stromleiter 12 unmittelbar angebracht bzw. befestigt sind. Die Anbringung bzw. die Befestigung der ungehäusten elektrischen Bauelemente 13 an die Stromleiter 12 erfolgt vorzugsweise - je nach Anwendung - mittels einer stark wärmeleitenden und/oder gut elektrisch leitenden Zwischenschicht 14. Beispielsweise können die ungehäusten elektrischen Bauelemente 13 mittels eines sehr gut wärmeleitenden und elektrisch leitenden Lots oder Leitklebers oder einer doppelseitig klebenden und wärmeleitenden Klebefolie auf die Stromleiter 12 angebracht und unmittelbar dort befestigt werden.

In den Figuren 3A und 3B ist ein solcher Stromleiter 12 mit einem darauf angebrachten ungehäusten elektrischen Bauelement 13 in einer Seitenansicht (Figur 3A) und in einer Querschnittsansicht (Figur 3B) entlang der Schnittlinie A-A der Figur 3A dargestellt. Der Stromleiter 12 ist als massives Formteil aus einem sehr gut stromleitenden Material, vorzugsweise Kupfer oder eine Kupferlegierung, herstellt. Vorzugsweise weist er einen rechteckigen oder quadratischen Querschnitt auf, und ist so dimensioniert, dass er Strom mit einer Stromstärke über 500 Ampere leiten kann.

Wie in Figur 2 erkennbar ist, sind die Stromleiter 12 mit dem ungehäusten elektrischen Bauelement 13 in die Ausnehmungen 11 des Trägerkörpers 10 eingesetzt. Dabei sind die Ausnehmungen 11 vorteilhafterweise derart an die Form des jeweiligen Stromleiters 12 angepasst, dass eine nahezu fugenfrei Einpassung der Stromleiter 12 in die Ausnehmungen 11 möglich ist.

Die in Figur 2 dargestellte Leiterplatte 9 weist ferner eine elektrisch isolierende Schicht 15 auf, welche den Trägerkörper 10, die Stromleiter 12 und die ungehäusten elektrischen Bauelemente 13 zumindest teilweise bedeckt. Diese elektrisch isolierende Schicht 15, welche im Fachjargon auch als "Prepreg" bezeichnet wird, besteht vorzugsweise aus in einer Kunststoffmatrix integrierten Endlosfasern. Sie kann unter hohem Druck und Temperatur auf den Trägerkörper 10 mit den darin eingesetzten Stromleitern 12 und den ungehäusten elektrischen Bauelementen 13 aufgepresst werden, wobei die Kunststoffmatrix dabei aushärtet. Es ergibt sich eine sehr zuverlässige und elektrisch isolierende Schicht.

Die Leiterplatte 9 weist ferner eine Schicht 16 aus elektrisch leitendem Material auf, welche als Leiterstruktur ausgebildet ist. Die elektrisch leitende Schicht 16 besteht vorzugsweise aus einer dünnen Kupferschicht, wobei die Leiterbahnenstruktur durch einen Ätzvorgang ausgebildet wird. Die elektrisch leitende Schicht 16 ist auf der elektrisch isolierenden Schicht 15 aufgebracht, so dass die elektrisch isolierende Schicht 15 zwischen der elektrisch leitenden Schicht 16 und dem Trägerkörper 10 angeordnet ist. Über diese als Leiterbahnenstruktur ausgebildete elektrisch leitende Schicht 16 können weitere elektrische Bauelemente 17 der Leiterplatte 9 untereinander elektrisch kontaktiert werden.

Die Leiterplatte 9 kann eine Vielzahl von weiteren elektrischen Bauelementen 17 aufweisen, welche durch einen Bestückvorgang auf der Seite angebracht sind, auf der sich auch die elektrisch leitende Schicht befindet. Die elektrischen Bauelemente sind dabei an die als Leiterbahnenstruktur ausgebildete elektrische Schicht angebunden und können untereinander verbunden sein. Ein oder mehrere dieser Bauelemente können als Steuerungselektronik 18 ausgebildet sein. Beispielsweise kann es sich um einen Mikroprozessor mit einem Speicherelement handeln.

In der elektrisch isolierenden Schicht 15 sind Durchbrüche 19 derart ausgebildet, dass die ungehäusten elektrischen Bauelemente 13 sowie zumindest einige der Stromleiter 12 durch diese Durchbrüche 19 elektrisch kontaktierbar sind. Im Ausführungsbeispiel sind beide ungehäusten elektrischen Bauelemente 13 sowie der mittlere und der rechte Stromleiter 12 (siehe Figur 2) über die Durchbrüche 19 elektrisch kontaktierbar. Die Durchbrüche 19 können je nach Anwendungsfall großflächig gefräst oder als Löcher oder Microvias gebohrt werden.

Im Ausführungsbeispiel der Figur 2 sind die ungehäusten elektrischen Bauelemente 13 und die Stromleiter 12 über die Durchbrüche 19 mit der elektrisch leitenden Schicht 16 elektrisch verbunden. Dies kann beispielsweise dadurch realisiert werden, dass während des Auftragens der elektrisch leitenden Schicht 16 auf die elektrisch isolierende Schicht 15, was meist durch einen galvanischen Vorgang geschieht, das elektrisch leitende Material auch in die Durchbrüche vordringt. Auf diese Weise können die Stromleiter 12 und die ungehäusten elektrischen Bauelemente 13, welche von der elektrisch isolierenden Schicht 15 großteils bedeckt sind, über die Durchbrüche 19 an die elektrisch leitende Schicht 16 angebunden und auch an beliebigen Bauelemente 17, 18 auf der Oberfläche der Leiterplatte 9 elektrisch angebunden werden.

Im Ausführungsbeispiel der Figur 2 handelt es sich bei den ungehäusten elektrischen Bauelementen 13 um Halbleiterschalter (z.b. Leistungs-MOSFETs), welche einerseits über die wärmeleitende und elektrisch leitende Schicht 14 mit dem zugehörigen Stromleiter 12 verbunden sind, aber auch über die Durchbrüche 19 und die elektrisch leitende Schicht 16 mit einem weiteren der Stromleiter 12 verbunden sind. Weiterhin sind die ungehäusten elektrischen Bauelemente 13 über die Durchbrüche 19 und die elektrisch leitende Schicht 16 mit der Steuerelektronik 18 der Leiterplatte elektrisch verbunden, so dass die Steuerelektronik 18 die Schaltzustände dieser Halbleiterschalter 13 je nach Bedarf variieren kann.

So kann beispielsweise der linke Stromleiter 12 mit dem elektrostatischen Energiespeicher 6 (siehe Figur 1), der mittlere Stromleiter 12 mit dem Motorgenerator 3 (siehe Figur 1) und der rechte Stromleiter 12 cmit dem elektrochemischen Energiespeicher 5 (siehe Figur 1) verbunden sein. Je nach Bedarf kann demnach die Steuerelektronik 18 die ungehäusten Halbleiterschalter derart schalten, dass der Stromfluß den gewünschten Empfänger erreicht.

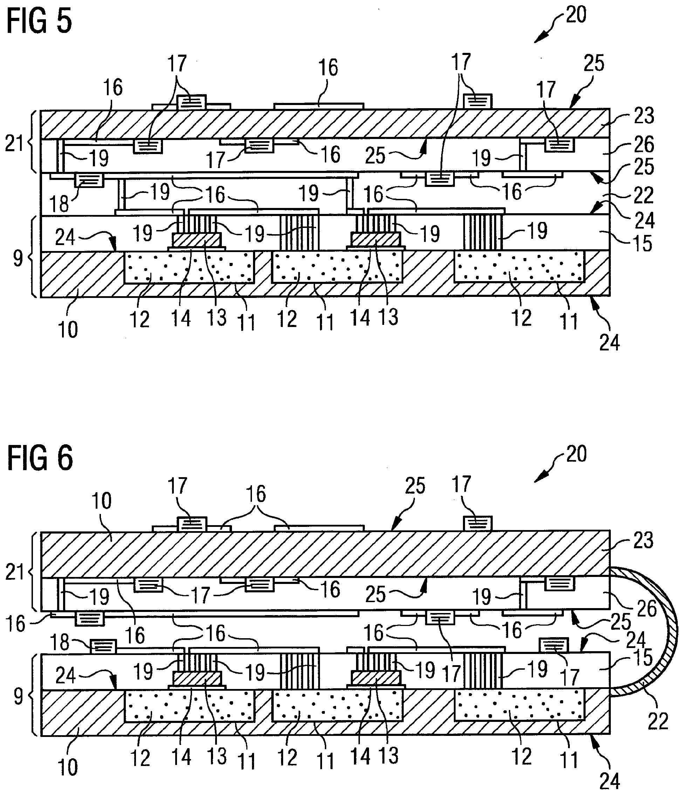

In Figur 5 ist ein erstes Ausführungsbeispiel eines Leiterplattensystems 20 dargestellt, wie es beispielsweise in der Steuervorrichtung 18 des Kraftfahrzeugs 1 (Figur 1) eingesetzt werden kann. Das Leiterplattensystem 20 weist eine erste Leiterplatte 9, wie sie beispielsweise in Figur 2 dargestellt ist, und eine zweite Leiterplatte 21 mit elektrischen Bauelementen 17 auf, wobei die beiden Leiterplatten 9, 21 durch einen Verbindungsabschnitt 22 aus elektrisch isolierendem Material miteinander verbunden sind.

Im Ausführungsbeispiel der Figur 5 ist der Verbindungsabschnitt 22 als elektrisch isolierende Schicht zwischen einer Hauptfläche 24 der ersten Leiterplatte 9 und einer Hauptfläche 25 der zweiten Leiterplatte 21 ausgebildet. Unter Hauptfläche 24 bzw. 25 ist eine Oberfläche der ersten Leiterplatte 9 bzw. der zweiten Leiterplatte 21 zu verstehen, welche mit elektrischen Bauelementen 17 bestückt werden kann oder bestückt ist. Der Verbindungsabschnitt 22 kann als Prepreg (in einer Kunststoffmatrix eingebettete Endlosfaser) ausgebildet sein, und verbindet daher auf feste und zuverlässig elektrisch isolierende Weise die beiden Hauptflächen 24, 25 der ersten Leiterplatte 9 und der zweiten Leiterplatte 21.

Im Ausführungsbeispiel der Figur 5 ist die zweite Leiterplatte 21 doppelseitig bestückt und als mehrlagige Leiterplatte ausgebildet (dies ist durch eine mehrlagige Bestückung der Unterseite der zweiten Leiterplatte 21 mit Bauelementen rein schematisch angedeutet). Die zweite Leiterplatte 21 weist einen eigenen Trägerkörper 23 aus elektrisch isolierendem Material (mit Epoxidharz getränkte Glasfasern auf). An den Hauptflächen 25 der Leiterplatte 21 sind jeweils elektrisch leitende Schichten 16 (vorzugsweise Kupfer) aufgebracht, welche als Leiterbahnstruktur ausgebildet ist. Auf den Hauptflächen 25 der zweiten Leiterplatte 21 sind elektrische Bauelemente 17 aufgebracht und an die Leiterbahnenstruktur angebunden. Die einzelnen Schichten sind durch eine weitere elektrisch isolierende Schicht 26 getrennt, welche Durchbrüche 19 aufweist. Einige elektrische Bauelemente 17 unterschiedlicher Schichten sind über die Durchbrüche 19 untereinander elektrisch verbunden.

Der aus elektrisch isolierendem Material bestehende Verbindungsabschnitt 22 zwischen der ersten Leiterplatte 9 und der zweiten Leiterplatte 21 weist ebenfalls Durchbrüche 19 auf, so dass die elektrischen Bauelemente 17 der ersten Leiterplatte 9 und die elektrischen Bauelemente 17 der zweiten Leiterplatte 21 untereinander zumindest teilweise miteinander elektrisch verbunden sind.

Auf diese Weise ist es möglich, dass beispielsweise die Steuerelektronik 18 für die Halbleiterschalter der zweiten Leiterplatte angeordnet und über die Durchbrüche mit den ungehäusten Halbleiterschaltern 13 der ersten Leiterplatte 9elektrisch verbunden ist.

Ein weiteres Ausführungsbeispiel des Leiterplattensystems ist in Figur 6 dargestellt. Dieses Ausführungsbeispiel unterscheidet sich von dem Ausführungsbeispiel in Figur 5 dadurch, dass der Verbindungsabschnitt 22 nicht als zwischen den Hauptflächen 24, 25 angeordnete elektrisch isolierende Schicht ausgebildet ist. Vielmehr weisen die erste Leiterplatte 9 und die zweite Leiterplatte 21 einen gemeinsamen Trägerkörper 10 auf, wobei der Verbindungsabschnitt 22 einen zwischen der ersten Leiterplatte 9 und der zweiten Leiterplatte 21 befindlichen Abschnitt der gemeinsamen Trägerplatte 10 darstellt. Der Verbindungsabschnitt 22 ist dabei derart geformt, dass zwei Hauptflächen 24 bzw. 25 der ersten Leiterplatte 9 bzw. der zweiten Leiterplatte 21 einander zugewandt sind. Dazu ist der Verbindungsabschnitt 22 um 180° Grad gebogen. Um den Biegevorgang zu erleichtern kann der Verbindungsabschnitt im Querschnitt verjüngt und für den Biegeprozess erwärmt werden. Diese Ausgestaltung des Leiterplattensystems 20 bietet eine sehr gute elektrische Isolierung der beiden Leiterplatten 24, 25 bei gleichzeitig geringem Platzbedarf. Weiterhin unterscheidet sich dieses Leiterplattensystem 20 der Figur 6 von dem Leiterplattensystem 20 der Figur 5 dadurch, dass die Steuerelektronik 18 für die Halbleiterschalter lediglich auf der ersten Leiterplatte 9 angeordnet sind.

Durch diese elektrische Trennung der beiden Leiterplatten 24, 25 kann die erste Leiterplatte 9 beispielsweise für Hochstromanwendungen und die zweite Leiterplatte für Niederstromanwendungen ausgebildet sein.

## Patentansprüche

1. Leiterplatte (9) für elektrische Bauelemente (17), mit
- einen Trägerkörper (10),
- mindestens einem Stromleiter (12), welcher als Formteil ausgebildet ist, und
- zumindest einem ungehäusten elektrischen Bauelement (13), welches unmittelbar an dem Stromleiter (12) befestigt ist, **dadurch gekennzeichnet, dass**
die Leiterplatte ferner umfasst:
- mindestens eine Schicht (15) aus elektrisch isolierendem Material, welche den Trägerkörper (10), den mindestens einen Stromleiter (12) und das zumindest eine ungehäuste elektrische Bauelement (13) zumindest teilweise bedeckt,
- wobei die Schicht (15) aus elektrisch isolierendem Material zumindest einen Durchbruch (19) aufweist, durch den das zumindest eine ungehäuste elektrische Bauelement (13) elektrisch kontaktierbar ist.

2. Leiterplatte (9) nach Anspruch 1, wobei der mindestens eine Stromleiter (12) als massiver Flachleiter mit rechteckigem Querschnitt ausgebildet ist.

3. Leiterplatte (9) nach einem der Ansprüche 1 bis 2, wobei der mindestens eine Stromleiter (12) ausgebildet ist, um Strom mit Stromstärken über 500 Ampere zu leiten.

4. Leiterplatte (9) nach einem der Ansprüche 1 bis 3, wobei das ungehäuste elektrische Bauelement (13) an dem Stromleiter (12) mittels einer dazwischenliegenden Schicht (14) aus wärmeleitendem Material befestigt ist.

5. Leiterplatte (9) nach Anspruch 1, mit zumindest zwei Stromleitern (12), welche als Formteil ausgebildet sind, wobei es sich bei zumindest einem ungehäusten elektrischen Bauelement (13) um einen Halbleiterschalter handelt, der an einem der Stromleiter (12) befestigt und durch den zumindest einen Durchbruch (19) in der elektrisch isolierenden Schicht (15) mit dem zweiten Stromleiter (12) elektrisch verbunden ist.

6. Leiterplatte (9) nach einem der Ansprüche 1 und 5, mit zumindest einer Steuerelektronik (18), welche durch den Durchbruch (19) mit dem ungehäusten elektrischen Bauelement (13) elektrisch verbunden ist.

7. Leiterplatte (9) nach einem der Ansprüche 1, 5 und 6, wobei der Trägerkörper (10) zumindest eine Ausnehmung (11) zur Aufnahme des Stromleiters (12) aufweist, und wobei der mindestens eine Stromleiter (12) in der Ausnehmung (11) des Trägerkörpers (10) angeordnet ist.

8. Leiterplatte (9) nach einem der Ansprüche 1 und 5 bis 7, mit einer Schicht (16) aus elektrisch leitendem Material, welche auf der elektrisch isolierenden Schicht (15) aufgebracht und als elektrische Leiterstruktur ausgebildet ist, und wobei das ungehäuste elektrische Bauelement (13) durch den mindestens einen Durchbruch (19) mit der elektrisch leitenden Schicht elektrisch verbunden ist.

9. Leiterplattensystem (20) mit
- zumindest einer ersten Leiterplatte (9) nach einem der Ansprüche 1 bis 8,
- zumindest einer zweiten Leiterplatte (21) mit elektrischen Bauelementen (17),
- zumindest einem Verbindungsabschnitt (22) aus elektrisch isolierendem Material, mittels dem die erste Leiterplatte (9) und die zweite Leiterplatte (21) miteinander verbunden sind.

10. Leiterplattensystem (20) nach Anspruch 9, wobei der Verbindungsabschnitt (22) als elektrisch isolierende Schicht zwischen einer Hauptfläche (24) der ersten Leiterplatte (9) und einer Hauptfläche (25) der zweiten Leiterplatte (21) ausgebildet ist.

11. Leiterplattensystem (20) nach Anspruch 9, wobei
- die erste Leiterplatte (9) und die zweite Leiterplatte (21) einen gemeinsamen Trägerkörper (10) aufweisen,
- ein zwischen der ersten Leiterplatte (9) und der zweiten Leiterplatte (21) befindlicher Abschnitt des gemeinsamen Trägerkörpers (10) den Verbindungsabschnitt (22) darstellt und welcher derart verformt ist, dass zwei Hauptflächen (24, 25) der ersten Leiterplatte (9) und der zweiten Leiterplatte (21) einander zugewandt sind.

12. Leiterplattensystem (20) nach einem der Ansprüche 9 bis 11, wobei die erste Leiterplatte (9) und/oder die zweite Leiterplatte (21) als mehrlagige Leiterplatte ausgebildet sind.

13. Leiterplattensystem (20) nach einem der Ansprüche 9 bis 12, wobei die zweite Leiterplatte (21) eine Steuerelektronik (18) ausweist.

14. Kraftfahrzeug (1) mit
- zumindest einem elektrischen Motorgenerator (3),
- zumindest einem elektrischen Energiespeicher (5, 6), welcher mit dem Motorgenerator (3) elektrisch verbunden ist, und
- einer Steuerungsvorrichtung (4) zum Steuern des elektrischen Energieflusses zwischen dem mindestens einen elektrischen Energiespeicher (5, 6) und dem mindestens einen Motorgenerator (3), mit zumindest einer Leiterplatte (9) nach einem der Ansprüche 1 bis 8.

## Claims

1. Printed circuit board (9) for electric components (17), comprising
- a carrier body (10),
- at least one current conductor (12) which is embodied as a molded part, and
- at least one unhoused electric component (13) which is attached directly to the current conductor (12),
**characterized in that** the printed circuit board furthermore comprises:
- at least one layer (15) made of electrically insulating material, which layer (15) at least partially covers the carrier body (10), the at least one current conductor (12) and the at least one unhoused electric component (13),
- wherein the layer (15) made of electrically insulating material has at least one breakthrough (19) through which electrical contact can be made with the at least one unhoused electric component (13).

2. Printed circuit board (9) according to Claim 1, wherein the at least one current conductor (12) is embodied as a solid ribbon conductor with a rectangular cross section.

3. Printed circuit board (9) according to one of Claims 1 to 2, wherein the at least one current conductor (12) is designed to conduct current with current strengths above 500 amperes.

4. Printed circuit board (9) according to one of Claims 1 to 3, wherein the unhoused electric component (13) is attached to the current conductor (12) by means of an intermediate layer (14) made of heat-conducting material.
- a carrier body (10),
- at least one layer (15) made of electrically insulating material, which layer (15) at least partially covers the carrier body (10), the at least one current conductor (12) and the at least one unhoused electric component (13),

5. Printed circuit board (9) according to Claim 1, having at least two current conductors (12) which are embodied as a molded part, wherein the at least one unhoused electric component (13) is a semiconductor switch which is attached to one of the current conductors (12) and is electrically connected to the second current conductor (12) through the at least one breakthrough (19) in the electrically insulating layer (15).

6. Printed circuit board (9) according to one of Claims 1 and 5, having at least one electronic control system (18) which is electrically connected to the unhoused electric component (13) through the breakthrough (19).

7. Printed circuit board (9) according to one of Claims 1, 5 and 6, wherein the carrier body (10) has at least one cutout (11) for accommodating the current conductor (12), and wherein the at least one current conductor (12) is arranged in the cutout (11) of the carrier body (10).

8. Printed circuit board (9) according to one of Claims 1 and 5 to 7, having a layer (16) made of electrically conductive material, which layer (16) is applied to the electrically insulating layer (15) and is embodied as an electrical conductor structure, and wherein the unhoused electric component (13) is electrically connected to the electrically conductive layer through the at least one breakthrough (19).

9. Printed circuit board system (20) comprising
- at least a first printed circuit board (9) according to one of Claims 1 to 8,
- at least a second printed circuit board (21) with electric components (17),
- at least one connecting section (22) made of electrically insulating material, by means of which the first printed circuit board (9) and the second printed circuit board (21) are connected to one another.

10. Printed circuit board system (20) according to Claim 9, wherein the connecting section (22) is embodied as an electrically insulating layer between a main face (24) of the first printed circuit board (9) and a main face (25) of the second printed circuit board (21).

11. Printed circuit board system (20) according to Claim 9, wherein
- the first printed circuit board (9) and the second printed circuit board (21) have a common carrier body (10),
- a section of the common carrier body (10), located between the first printed circuit board (9) and the second printed circuit board (21), constitutes the connecting section (22) and is shaped in such a way that two main faces (24, 25) of the first printed circuit board (9) and of the second printed circuit board (21) face one another.

12. Printed circuit board system (20) according to one of Claims 9 to 11, wherein the first printed circuit board (9) and/or the second printed circuit board (21) are embodied as a multi-layer printed circuit board.

13. Printed circuit board system (20) according to one of Claims 9 to 12, wherein the second printed circuit board (21) has an electronic control system (18).

14. Motor vehicle (1) comprising
- at least one electric motor generator (3),
- at least one electrical energy accumulator (5, 6) which is electrically connected to the motor generator (3), and
- a control device (4) for controlling the flow of electrical energy between the at least one electrical energy accumulator (5, 6) and the at least one motor generator (3), having at least one printed circuit board (9) according to one of Claims 1 to 8.

## Revendications

1. Carte de circuit imprimé (9) pour des composants électriques (17), comportant
- un corps de support (10),
- au moins un conducteur électrique (12) se présentant sous la forme d'une pièce moulée, et
- au moins un composant électrique dépourvu de boîtier (13), fixé directement sur le conducteur électrique (12),
**caractérisée en ce que** la carte de circuit imprimé comprend en outre :
- au moins une couche (15) constituée d'un matériau électriquement isolant qui recouvre au moins partiellement le corps de support (10), l'au moins un conducteur électrique (12) et l'au moins un composant électrique dépourvu de boîtier (13),
- dans lequel la couche (15) constituée de matériau électriquement isolant comporte au moins une traversée (19) par l'intermédiaire de laquelle un contact électrique peut être établi avec l'au moins un composant électrique dépourvu de boîtier (13).

2. Carte de circuit imprimé (9) selon la revendication 1, dans laquelle l'au moins un conducteur électrique (12) se présente sous la forme d'un conducteur plat massif de section transversale rectangulaire.

3. Carte de circuit imprimé (9) selon l'une quelconque des revendications 1 à 2, dans laquelle l'au moins un conducteur électrique (12) est conçu pour le passage d'un courant présentant des intensités supérieures à 500 Ampères.

4. Carte de circuit imprimé (9) selon l'une quelconque des revendications 1 à 3, dans laquelle le composant électrique dépourvu de boîtier (13) est fixé au conducteur électrique (12) au moyen d'une couche intermédiaire (14) constituée d'un matériau thermiquement conducteur.

5. Carte de circuit imprimé (9) selon la revendication 1, comportant au moins deux conducteurs électriques (12) se présentant sous la forme d'une pièce moulée, dans laquelle l'au moins un composant électrique dépourvu de boîtier (13) est un commutateur à semi-conducteur qui est fixé au conducteur électrique (12) et est connecté électriquement au second conducteur électrique (12) par l'intermédiaire de l'au moins une traversée (19) dans la couche électriquement isolante (15).

6. Carte de circuit imprimé (9) selon l'une quelconque des revendications 1 et 5, comportant au moins une électronique de commande (18) qui est connectée électriquement par l'intermédiaire de la traversée (19) au composant électrique dépourvu de boîtier (13).

7. Carte de circuit imprimé (9) selon l'une quelconque des revendications 1, 5 et 6, dans laquelle le corps de support (10) comporte au moins un évidement (11) destiné à recevoir le conducteur électrique (12), et dans laquelle l'au moins un conducteur électrique (12) est disposé dans l'évidement (11) du corps de support (10).

8. Carte de circuit imprimé (9) selon l'une quelconque des revendications 1 et 5 à 7, comportant une couche (16) constituée d'un matériau électriquement conducteur, qui est déposée sur la couche électriquement isolante (15) et se présente sous la forme d'une structure électriquement conductrice, et dans laquelle le composant électrique dépourvu de boîtier (13) est connecté électriquement par l'intermédiaire de l'au moins une traversée (19) à la couche électriquement conductrice.

9. Système de carte de circuit imprimé (20) comportant
- au moins une première carte de circuit imprimé (9) selon l'une quelconque des revendications 1 à 8,
- au moins une seconde carte de circuit imprimé (21) comportant des composants électriques (17),
- au moins une section de connexion (22) constituée d'un matériau électriquement isolant, au moyen de laquelle la première carte de circuit imprimé (9) et la seconde carte de circuit imprimé (21) sont reliées l'une à l'autre.

10. Système de carte de circuit imprimé (20) selon la revendication 9, dans lequel la section de connexion (22) se présente sous la forme d'une couche électriquement isolante entre une surface principale (24) de la première carte de circuit imprimé (9) et une surface principale (25) de la seconde carte de circuit imprimé (21).

11. Système de carte de circuit imprimé (20) selon la revendication 9, dans lequel
- la première carte de circuit imprimé (9) et la seconde carte de circuit imprimé (21) comportent un corps de support (10) commun,
- une partie du corps de support (10) commun se trouvant entre la première carte de circuit imprimé (9) et la seconde carte de circuit imprimé (21) constitue la section de connexion (22) et est configurée de manière à ce que deux surfaces principales (24, 25) de la première carte de circuit imprimé (9) et de la seconde carte de circuit imprimé (21) soient en face l'une de l'autre.

12. Système de carte de circuit imprimé (20) selon l'une quelconque des revendications 9 à 11, dans lequel la première carte de circuit imprimé (9) et/ou la seconde carte de circuit imprimé (21) se présentent sous la forme de cartes de circuits imprimés multicouches.

13. Système de carte de circuit imprimé (20) selon l'une quelconque des revendications 9 à 12, dans lequel la seconde carte de circuit imprimé (21) comporte une électronique de commande (18).

14. Véhicule automobile (1) comportant
- au moins un moteur-générateur électrique (3),
- au moins un accumulateur d'énergie électrique (5, 6) qui est électriquement relié au moteur-générateur (3), et
- un dispositif de commande (4) pour commander le flux d'énergie électrique entre l'au moins un accumulateur d'énergie électrique (5, 6) et l'au moins un moteur-générateur (3), comportant au moins une carte de circuit imprimé (9) selon l'une quelconque des revendications 1 à 8.
